Europäisches Patentamt

European Patent Office

Office européen des brevets

(19)

(11) Publication number: **0 211 622**
**B1**

# EUROPEAN PATENT SPECIFICATION

(45) Date of publication of patent specification: **14.03.90**

(21) Application number: **86305902.8**

(22) Date of filing: **31.07.86**

(51) Int. Cl.⁵: **H 01 L 27/02, H 01 L 27/08**

(54) Mos integrated circuit having a protection circuit which includes divided protection resistors.

(30) Priority: **31.07.85 JP 168881/85**

(43) Date of publication of application:
**25.02.87 Bulletin 87/09**

(45) Publication of the grant of the patent:
**14.03.90 Bulletin 90/11**

(84) Designated Contracting States:
**DE FR GB**

(56) References cited:
**DE-A-2 041 266**

**PATENTS ABSTRACTS OF JAPAN, vol. 6, no.
247 (E-146)1125r, 7th December 1982; & JP-A-57
147 278 (FUJITSU K.K.) 11-09-1982**

**PATENTS ABSTRACTS OF JAPAN, vol. 9, no.
102 (E-312)1825r, 4th May 1985; & JP-A-59 229
856 (ROOMU K.K.) 24-12-1984**

**PATENTS ABSTRACTS OF JAPAN, vol. 6, no.
144 (E-122)1022r, 3rd August 1982; & JP-A-57 68
071 (NIPPON DENKI K.K.) 26-04-1982**

(73) Proprietor: **NEC CORPORATION
33-1, Shiba 5-chome, Minato-ku
Tokyo 108 (JP)**

(72) Inventor: **Kamaya, Michinori
c/o NEC Corporation 33-1 Shiba 5-chome
Minato-ku Tokyo (JP)**

(74) Representative: **Pritchard, Colin Hubert et al
Mathys & Squire 10 Fleet Street
London EC4Y 1AY (GB)**

Courier Press, Leamington Spa, England.

# Description

The present invention relates to a MOS integrated circuit, and more particularly to a protection circuit incorporated in the MOS integrated circuit for protecting MOS FET's from a high voltage applied to an input terminal.

In a MOS integrated circuit, a plurality of MOS FET's are formed on a single semiconductor substrate and wired to form an electrical circuit. An input signal and a power supply voltage are applied to the MOS FET's through input terminals formed on the same semiconductor substrate. Especially, the input signal is applied to the gate electrode or electrodes of the MOS FET's which are formed on thin gate insulator films. The gate insulator film is likely to be broken down by a high voltage applied to the gate electrode. Thus, the MOS integrated circuit has such a drawback that the composed MOS FET's are likely to be broken down by the high voltage accidentally applied to their gate electrodes through input terminals.

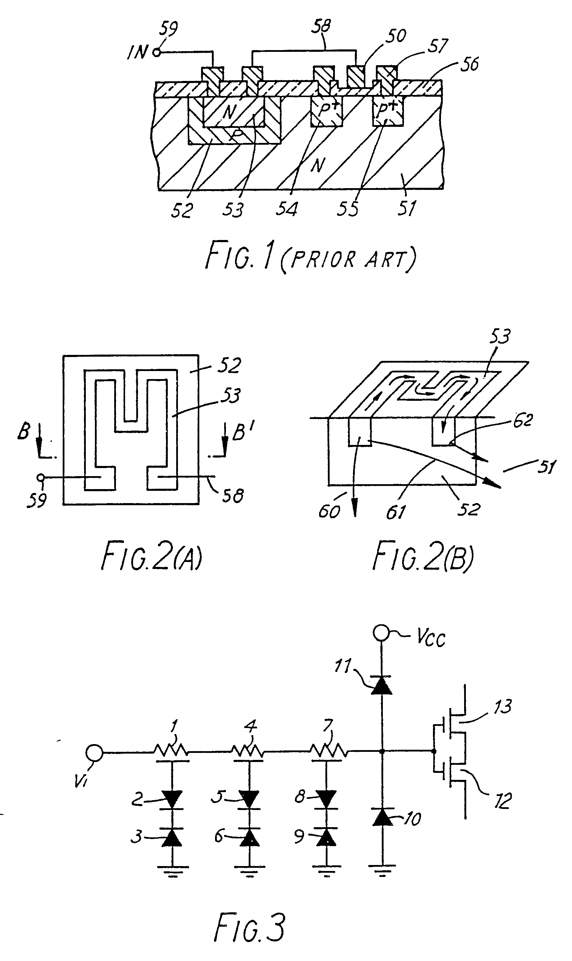

Many protection circuits have been proposed to protect the MOS FET's. For instance, one of such protection circuits is taught in a Japanese Published Patent (KOKAI) No. 57-68071 which is shown in Fig. 1 of the attached drawings. This example of prior arts has a feature that a MOS FET is protected from both of positive and negative high voltage inputs.

More specifically, a P-well region 52 and P$^+$ regions 54 and 55 as source and drain regions of a MOS FET are formed on an N-type silicon substrate 51. A diffusion resistor 53 of an N-type is formed in the P-well region 52. Contacts of wiring layers 57 with the diffusion resistor 53 and the P$^+$ regions 54 and 55 are made through contact holes in the surface passivation layer 56 of silicon dioxide. The reference numeral 58 denotes the wiring by the wiring layer 57.

An input signal applied to the input terminal 59 is transmitted through the diffusion resistor 53 to a gate electrode 50 which is disposed on a gate insulator film between the P$^+$ regions 54 and 55. Since the diffusion resistor 53 is formed in the P-well region 52, the resistor 53 is coupled with the substrate 51 through a series circuit of an N-P junction diode and a P-N junction diode. An input signal having a normal voltage of either positive or negative polarity is isolated from the substrate 51 by one of the diodes. On the contrary, if an abnormally high voltage signal with a positive polarity is applied to the input terminal 59, the voltage applied to the gate electrode 50 is restricted at a voltage higher than a break-down voltage of the N-P junction diode by a forward bias voltage of the P-N junction diode. Similarly, if an abnormally high voltage signal with a negative polarity is applied, the voltage at the gate electrode 50 is limited at a voltage lower than a break-down voltage of the P-N junction diode by a forward bias voltage of the N-P junction diode.

In this manner, the MOS FET is protected from the abnormally high voltage having either positive or negative polarity. Thus protection effect is improved by increasing the resistance value of the diffusion resistor 53. Therefore, the inventor designed the diffusion resistor 53 as a pattern having a winding path as shown in Fig. 2(A). A new problem arose as explained with reference to Fig. 2(B) which is a perspective view of the resistor 53 with a sectional view taken along B-B' of Fig. 2(A.

When an abnormally high voltage having a positive polarity is applied to the input terminal 59, the N-P junction between the resistor 53 and the P-well region 52 is broken down to produce a current flow from the input terminal 59 to the substrate 51. Such current flows through many paths 60, 61 and 62. The current path 60 is a path from the input side of the resistor 53 directly to the nearest part of the substrate 51. Another current path 61 passes near the output side of the resistor 53. The rest 62 passes inside the resistor 53 and crosses the resistor 53 at the output side. In comparison between the two paths 61 and 62 both of which pass the part of the P-well region near the output side of the resistor 53, the path 61 is shorter than the path 62. As a result, the voltage at the part of the P-well region 52 near the output side of the resistor 53 becomes higher than the voltage at the output side of the resistor 53. This means that the P-N junction between the resistor 53 and the P-well region 52 is forward biased at the output side of the resistor 53. Accordingly, the resistance of the P-well region 52 between the input and output sides of the resistor 53 is connected in parallel with the resistor 53 to lower the effective resistance of the resistor 53.

If the resistance of the resistor in the protection circuit is low, the applied high voltage cannot be sufficiently lowered. Therefore, the protection resistor having a winding path does not have a sufficient protection effect against the input having the abnormally high positive voltage. This drawback does not occur if a protection resistor having a straight pattern is employed. The resistor of the straight pattern, however, occupies a large area on a semiconductor chip and is not suitable to be used in a large-scale integrated circuit.

JP—A—59-229856 discloses a resistor constructed from a plurality of resistor regions which are formed in respective well regions of the opposite conductive type and which are connected together in series. The well regions are allowed to float.

It is a primary object of the present invention to provide a MOS integrated circuit having an input protection circuit which performs a reliable protection function and which is suitable to be used in a large-scale integrated circuit.

According to the present invention there is provided a semiconductor device comprising a semiconductor substrate of one conductivity type, an MOS field effect transistor formed in said semiconductor substrate, an input terminal formed on said semiconductor substrate, a well region of the other conductivity type formed in said semiconductor substrate, a resistor region of said on conductivity type formed in said well region, and a means for connecting said resistor region between said input terminal and a gate of said MOS field effect transistor to form a protective circuit for said MOS field effect transistor, characterised in that said well region is divided into a plurality of separate well regions, and that said resistor region is also divided into a plurality of separate resistor regions each of which is formed in a respective one of said separate well regions, said separate resistor regions being connected together in series.

Suitably, a device according to the present invention, includes P- and N-channel MOSFET's a first diode region of the other conductivity type formed in the semiconductor substrate, an additional well region of the other conductivity type formed in the semiconductor substrate, a second diode region of the one conductivity type formed in the second well region, means for supplying a power voltage to the additional well region, and means for connecting the first and second diode regions to the connecting portion between the series connection of the resistor regions and the circuit block.

The protection resistor of the present invention is divided into a plurality of resistors, each part being formed in corresponding one of the well regions. Therefore, if the P-N junction between the first resistor and its well region is broken down by an application of abnormally high voltage, some of the rest is kept their separation from their well region. Therefore, the lowering of the resistance is minimised to keep the protection effect. The same advantage is obtained if the respective divided resistors are arbitrarily located. The winding pattern of the protection resistor is possible to minimise the whole occupation area. Thus, the protection circuit of the present invention is preferably applied to a large-scale integrated circuit.

The above and further object, features and advantages of the present invention will become more apparent from the following detailed description of embodiments taken in conjunction with the accompanying drawings, wherein:

Fig. 1 is a sectional view of a part of the MOS integrated circuit in the prior art;

Fig. 2(A) is a plan view of a diffusion resistor in an input protection circuit which has been designed by the inventor in the course of devising the protection circuit of the present invention, Fig. 2(B) being a perspective view of the resistor shown in Fig. 2(A) with a cross section taken along the line B-B' of Fig. 2(A);

Fig. 3 is a circuit diagram showing a principle of the present invention;

Fig. 4(A) is a plan view showing a preferred embodiment of the present invention, Fig. 4(B) being a sectional view taken along the line X-X' of Fig. 4(A), Fig. 4(C) being a sectional view taken along the line Y-Y' of Fig. 4(A), and Fig. 4(D) being a sectional view taken along the line Z-Z' of Fig. 4(A);

Fig. 5 is a graph representing the relationship between a voltage applied to the input terminal and a current flowing therethough; and

Fig. 6 is a sectional view showing resistors used in another embodiment of the present invention.

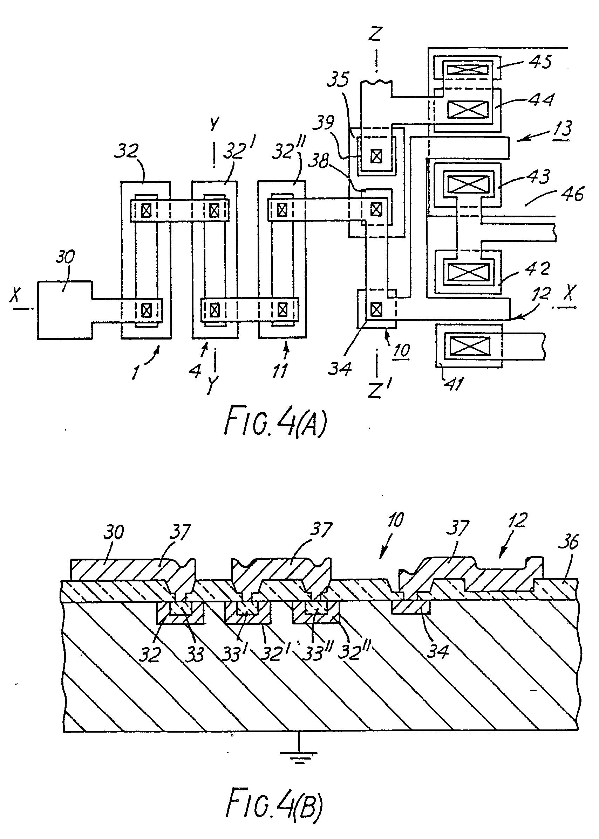

The input protection circuit of the present invention comprises a series connection of a plural number of diffused resistors, each formed in a separated well regions in a semiconductor substrate, as shown in Fig. 3. On a semiconductor substrate, there are formed a circuit block including MOS FET's 12 and 13, an input terminal $V_1$, a power supply terminal $V_{cc}$, a plural number of diffusion resistors 1, 4 and 7, and diodes 10 and 11. As above-mentioned, each of the diffusion resistors 1, 4 and 7 is formed in a corresponding one of separated well regions and accompanies a series circuit of diodes 2 and 3, 5 and 6 or 8 and 9. The diodes 2, 5 and 8 are P-N junctions between the diffusion resistors 1, 4 and 7 and the well regions. The diodes 3, 6 and 9 are P-N junctions between the well regions and the semiconductor substrate. Thus, the directions of the diodes in the series connection are opposite to each other.

The diodes 2, 5 and 8 break down when an abnormally high negative voltage is applied to the input terminal $V_1$ by, for example applying electro-static charges to the terminal $V_1$. The diodes 3, 6 and 9 break down when an abnormally high positive voltage is applied to the input terminal $V_1$. The diodes 2 and 3 break down more easily than the other. If the diode 2 breaks down, the resistance of the diffusion resistor becomes small. At this time, however, resistances of the other diffusion resistors 4 and 7 are maintained, because the diodes 5 and 8 do not break down. The total resistance of the diffusion resistors 1, 4 and 7 lowers only to keep the normal protection function.

The number of diffusion resistors 1, 4 and 7 is preferably selected in a range between two and five. The number more than five is not only meaningless for the maintenance of protection function but requires a large occupation area on a semiconductor substrate which is to be avoided in the design of a large-scale integrated circuit.

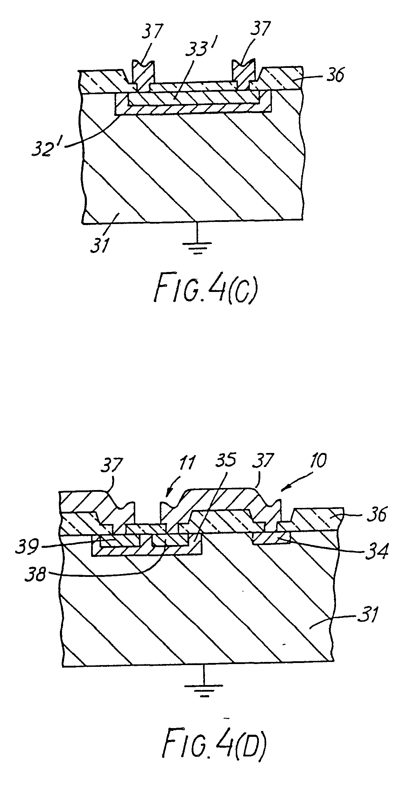

A preferred embodiment embodying the circuit of Fig. 3 is shown in Figs. 4(A) to 4(D). A P type silicon substrate having an impurity concentration of $1 \times 10^{15}$ cm$^{-3}$ is used as a silicon substrate 31. N-well regions 32, 32', 32'', 35 and 49 are formed in the substrate 31 with an impurity concentration of $1 \times 10^{16}$cm$^{-3}$. P type diffusion resistors 33, 33' and 33'' are formed in the N-well regions 32, 32', 32'', respectively, with an impurity concentration of $5 \times 10^{19}$ cm$^{-3}$. An N type diode region 34 is formed in the substrate 31. A P type diode region 38 is formed in the N-well region 35. N type source and drain regions 41, and 42 are formed in the substrate 31 to form an N-channel MOS FET 12. P type source and drain regions 44 and 43 are similarly formed in the N-well regions 46 to form a P-channel MOS FET 13. A power voltage is supplied to the N-well regions 35 and 46 through N$^+$ regions 39 and 45, respectively. Surface of the substrate 31 is passivated by a silicon dioxide layer 36. An input terminal 30, gate electrodes of the MOS FET's 12 and 13 and wiring layers 37 are formed of evaporated aluminum. The wiring layer 37 is connected with regions in the substrate 31 through contact holes of the silicon oxide layer 36 to form an electrical circuit shown in Fig. 3.

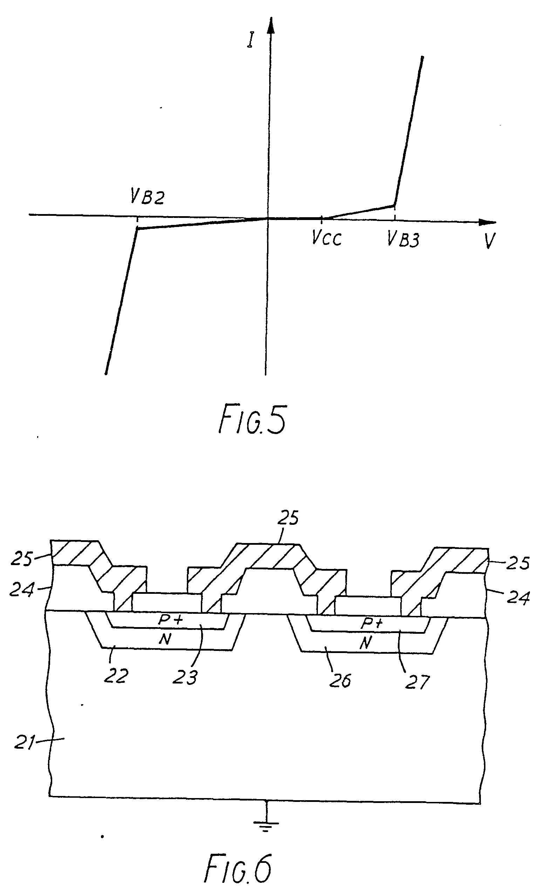

When an abnormally high voltage is applied to the input terminal 30, one of P-N junctions between the diffusion resistor 33 and the N-well region 32 and between the N-well region 32 and the substrate 31 break down to produce a current flowing through the input terminal 30. The value of the current depends on the value of the applied voltage to the input terminal 30. The relationship between the voltage and the current is shown in Fig. 5.

When the voltage takes the value between the grounding potential and the power supply voltage Vcc (for example, 5V), any of the diodes does not break ff and the current is very small. If the voltage becomes higher than the power supply voltage Vcc, the current flow through the diffusion resistors 1(33), 4(33') and 7(33'') and the diode 11(38 and 35), the value being limited by the diffusion resistors 1(33), 4(33') and 7(33''). At a time when the voltage further increased to take a value higher than a breakdown voltage $V_{B3}$ (for example, 92 V) of the diode 3 between the N-well region 32 and the substrate 31, the current suddenly increases to flow through the diffusion resistor 33, the N-well region 32 and the substrate 31. This large current does not flow through the diffusion resistor 33' and 33''. Therefore, the voltage at the junction between the diffusion resistor 33'' and the diodes 10 and 11 is normally limited by the diode 11. Thus, the circuit block including the MOS FET's 12 and 13 are protected from being broken down.

On the contrary, the voltage applied to the input terminal 30 lowers than the grounding potential, the current flows through the diode 10 and the diffusion resistors 1(33), 4(33') and 7(33''), the value being limited by the diffusion resistors 1(33), 4(33') and 7(33''). If the voltage further lowers to take a value lower than a breakdown voltage $V_{B2}$ (for example, −14 V) of the diode 2 between the diffusion resistor 33 and the N-well region 32, a large current flows through the substrate 31, the N-well region 32 and the diffusion resistor 33. At this time, since the diffusion resistors 33' and 33'' are kept separated from the substrate 31, the voltage at the connection point between the diffusion resistor 33' and the diodes 10 and 11 is limited by the diode 10. Thus the circuit block is protected from being broken down.

As above-explained, the circuit block of MOS FET's are reliably protected from being broken down by high voltage of both polarities. The protection is performed for the gate insulator film of MOS FET. Therefore, the protected circuit block is not limited to a C-MOS FET circuit including P- and N-channel MOS FET's but may be a circuit composed of MOS FET's of one channel type or may be a discrete MOS FET.

According to the preferred embodiment of the present invention, the diffusion resistors 33, 33' and 33'' are disposed in parallel which is suitable for compactness of the input protection circuit. The diffusion resistors may be disposed in series as shown in Fig. 6 which is only a part of two diffusion resistors 23 and 27. Two N-well regions 22 and 26 are formed in a P type silicon substrate 21. P⁺ type diffusion resistors 23 and 27 are respectively formed in the N-well regions 22 and 26.

The surface of the substrate 21 is covered by a silicon dioxide layer 24 in which contact holes are opened. The two diffusion resistors 23 and 27 are connected in series with aluminum wiring layer 25 disposed on the silicon dioxide layer 25. The other construction is similar to the preferred embodiment of Figs. 4(A) to 4(D). In this embodiment, the same protection effect as the preferred embodiment of Figs. 4(A) to 4(D) is expected.

It is needless to say that the conductivity types of all the regions in the explained two embodiments may be changed to the other conductivity type. The diodes 10 and 11 may be neglected to only protect from a serge voltage which is produced by applying electrostic charges. At the protection operation, some of resistance is maintained. The CR time constant of the protection resistors and the gate capacitance does not become zero. Therefore, the increase of voltage at the gate electrode is smoothed not to reach the gate insulator breakdown voltage during the time of serge voltage.

## Claim

A semiconductor device comprising a semiconductor substrate (31) of one conductivity type, an MOS field effect transistor (12, 13) formed in said semiconductor substrate (31), an input terminal (30) formed on said semiconductor substrate (31), a well region (52) of the other conductivity type formed in said semiconductor substrate (31), a resistor region (53) of said one conductivity type formed in said well region (52), and a means for connecting said resistor region (53) between said input terminal (30) and a gate of said MOS field effect transistor (12, 13) to form a protective circuit for said MOS field effect transistor (12, 13), characterised in that said well region (52) is divided into a plurality of separate well regions (32, 32', 32''), and that said resistor region (53) is also divided into a plurality of separate resistor regions (33, 33', 33'') each of which is formed in a respective one of said separate well regions (32, 32', 32''), said separate resistor regions (33, 33', 33'') being connected together in series.

## Patentanspruch

halbleitervorrichtung mit einem Halbleiterträger (31) aus einem ersten Leitungstyp, einem MOS-Feldeffekttransistor (12, 13), der in dem Halbleiterträger (31) ausgebildet ist, einem Eingangsanschluß (30), der auf dem Halbleiterträger (31) ausgebildet ist, einem Schutzbereich (52) aus dem anderen Leitungstyp, der in dem Halbleiterträger (31) ausgebildet ist, einem Widerstandsbereich (52) aus dem ersten Leitungstyp, der in dem Schutzbereich (52) ausgebildet ist, und einem Mittel zum Anschließen des Widerstandsbereichs (53) zwischen dem Eingangsanschluß (30) und einem Tor des MOS-Feldeffekttransistors (12, 13), um eine Schutzschaltung für den MOS-Feldeffekttransistor (12, 13) zu bilden, dadurch gekennzeichnet, daß der Schutzbereich (52) in eine Vielzahl von getrennten Schutzbereichen (32, 32', 32'') unterteilt ist, und daß der Widerstandsbereich (53) ebenfalls in eine Vielzahl von getrennten Widerstandsbereichen (33, 33', 33'') unterteilt ist, von denen jeder jeweils in einem der getrennten Schutzbereiche (32, 32', 32'') ausgebildet ist, wobei die getrennten Widerstandsbereiche (33, 33', 33'') zusammen in Reihe verbunden werden.

**Revendication**

Dispositif à semi-conducteur comprenant un substrat (31) à semi-conducteur d'un type de conductivité, un transistor à effet de champ MOS (12, 13) formé dans le substrat (31) à semi-conducteur, une borne d'entrée (30) formée sur le substrat (31) à semi-conducteur, une région (52) à puits de l'autre type de conductivité formée dans le substrat (31) à semi-conducteur, une région (53) à résistance du premier type de conductivité formée dans la région (52) à puits, et un moyen pour connecter la région (53) à résistance entre le borne d'entrée (30) et une grille du transistor à effet de champ MOS (12, 13) pour constituer un circuit de protection pour le transistor à effet de champ MOS (12, 13), caractérisé en ce que:

—la région (52) à puits est divisée en une multitude de régions séparées à puits (32, 32', 32''), et en ce que la région (53) à résistance est également divisée en une multitude de régions séparées à résistance (33, 33', 33''), chacune étant formée dans une région respective parmi les régions séparées à puits (32, 32', 32''), les régions séparées à résistance (33, 33', 33'') étant connectées en série.

FIG. 1 (PRIOR ART)

FIG. 2(A)

FIG. 2(B)

FIG. 3

FIG.4(A)

FIG.4(B)

FIG.4(C)

FIG.4(D)

FIG.5

FIG.6